# FASCICULE DE BREVET EUROPEEN

(11) **EP 1 889 084 B1**
(45) Date de publication et mention de la délivrance du brevet: **26.08.2009**
(21) Numéro de dépôt: 06764852.7
(22) Date de dépôt: 07.06.2006
(51) Int. Cl.: G01R 31/319, G01R 31/00, H04L 1/24, H04B 3/04

(54) **MODULE DE TEST DE COMPATIBILITE ELECTROMAGNETIQUE D'UNE INTERFACE ETHERNET HAUT DEBIT EMBARQUEE SUR AVION**
MODULE ZUM TESTEN DER ELEKTROMAGNETISCHEN VERTRÄGLICHKEIT EINER HOCHGESCHWINDIGKEITS-ETHERNETSCHNITTSTELLE AN BORD EINES FLUGZEUGS
MODULE FOR TESTING ELECTROMAGNETIC COMPATIBILITY OF A HIGH-SPEED ETHERNET INTERFACE ONBOARD AN AIRCRAFT

(30) Priorité: 09.06.2005 FR 0551550
(43) Date de publication de la demande: 20.02.2008
(73) Titulaire: AIRBUS France, 31060 Toulouse (FR)
(72) Inventeur: FLOURENS, Franck, F-31500 Toulouse (FR); GAMBARDELLA, Eddie, F-31700 Blagnac (FR); HEINS, Patrick, F-81140 Castelnau de Montmiral (FR); BOISSON, Bernard, F-31490 Brax (FR); SANT-ANNA, Philippe, F-31530 Lasserre (FR); RIVAL, Joseph, F-31340 Villemur sur Tarn (FR)
(74) Mandataire: Ilgart, Jean-Christophe
(86) Numéro de dépôt international: PCT/FR2006/050532
(87) Numéro de publication internationale: WO 2006/131678

(56) Documents cités:
- EP-A- 0 513 992
- US-A- 6 121 779
- US-A1- 2003 204 611
- US-B1- 6 332 166
- PATENT ABSTRACTS OF JAPAN vol. 2003, no. 12, 5 décembre 2003 (2003-12-05) & JP 2003 264469 A (HITACHI KOKUSAI ELECTRIC INC), 19 septembre 2003 (2003-09-19)
- STEPHENS W E ET AL: "155.52 Mb/s data transmission on category 5 cable plant" COMPUTERS AND COMMUNICATIONS, 1995., CONFERENCE PROCEEDINGS OF THE 1995 IEEE FOURTEENTH ANNUAL INTERNATIONAL PHOENIX CONFERENCE ON SCOTTSDALE, AZ, USA 28-31 MARCH 1995, NEW YORK, NY, USA,IEEE, US, 28 mars 1995 (1995-03-28), pages 168-178, XP010149391 ISBN: 0-7803-2492-7

## Description

### DOMAINE TECHNIQUE

L'invention concerne un module de test de compatibilité électromagnétique d'une interface Ethernet haut débit embarquée sur avion.

### ÉTAT DE LA TECHNIQUE ANTÉRIEURE

La certification d'un réseau Ethernet embarqué sur avion implique la démonstration de la tenue électromagnétique des équipements en jeu.

L'augmentation des fréquences utilisées, par exemple 100 Mbit/s pour un réseau AFDX (« Avionics Full Duplex Switched Ethernet »), rend le problème particulièrement crucial dans le domaine avionique. Un test difficile à tenir, étant données les fréquences mises en jeu (10 KHz-400 MHz), est le test de susceptibilité aux rayonnements (« Radio Frequency Conducted Susceptibility »).

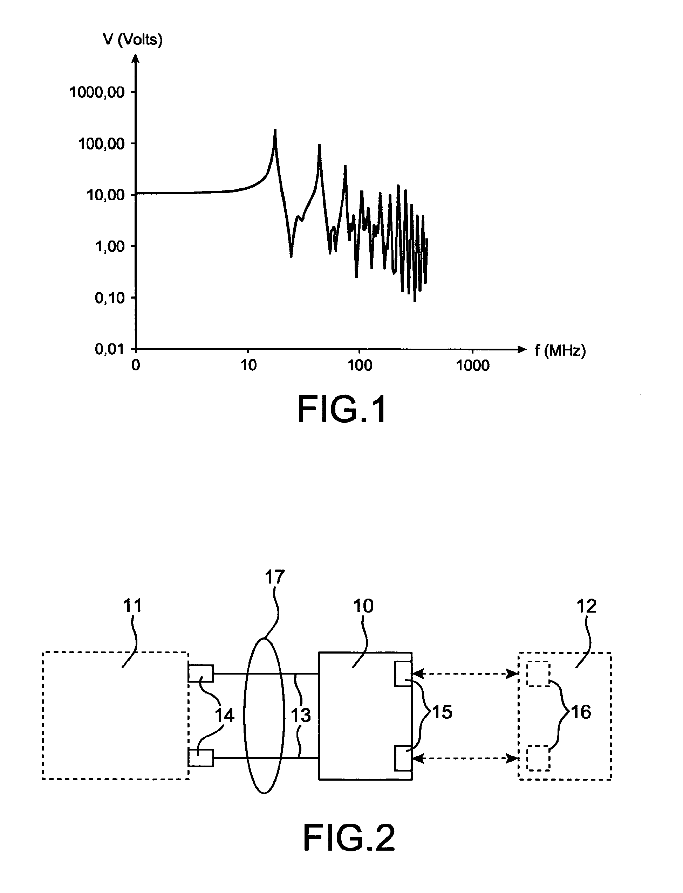

Une méthode de test de l'art connu, intitulée « Bulk Current Injection » ou BCI, est décrite dans le document référencé [1] en fin de description. Dans cette méthode on utilise une installation de test similaire à une installation avion avec une longueur de câble de 3,3 mètres. Une injection de courant, simulant une agression électromagnétique, est réalisée à l'aide d'un tore magnétique associé à un câble. Comme illustré sur la courbe de la figure 1, dans une telle configuration le câble entre en résonance dans la bande utile du signal (inférieure à 65 MHz), ce qui entraîne des zones de « sur test » (pics de tensions très importantes : supérieures à environ 100 volts) et des zones de « sous test » (creux de tensions très faibles : environ 60 millivolts).

Avec un câble de 4 mètres de longueur, les fréquences entre 20 et 40 MHz sont largement sous testées. Un tel mode de réalisation n'est donc acceptable que pour des bus dont les fréquences de fonctionnement sont situées en dessous de 20 MHz.

Par contre si la longueur de ce câble est limitée à 50 cm, les premières résonances sont repoussées plus loin en fréquence (au-delà de 80 MHz). Cependant, avec un câble d'une telle longueur, l'atténuation du signal, qui joue un rôle primordial dans la robustesse du signal, n'est pas prise en compte.

L'utilisation d'un tel câble de test pose, en outre, un problème de sensibilité à l'installation de test utilisée : Les résultats obtenus sont, en effet, très sensibles notamment à la longueur de câble utilisée et à la manière d'installer celui-ci, ce qui empêche une mise en oeuvre fiable et reproductible.

Les documents [4] et [5] divulguent différentes solutions aux problèmes concernant les câbles dans des tests à haute fréquences. Pour résoudre ces différents problèmes, l'invention a pour objet un module de test de compatibilité électromagnétique d'une interface Ethernet haut débit embarqués sur avion qui permet :
- de garantir une prise en compte de l'atténuation du signal,
- d'éviter de sous tester l'interface à cause des résonances qui apparaissent sur le câble utilisé au moment du test.

### EXPOSÉ DE L'INVENTION

L'invention concerne un module de test de compatibilité électromagnétique d'au moins une interface Ethernet haut débit embarquée sur avion, **caractérisé en ce qu**'il comprend :
- un câble d'une longueur inférieure à 1 mètre, par exemple d'une longueur d'environ 50 cm, dont les extrémités sont équipées de contacts avion,
- deux connecteurs standard compatibles d'un équipement de test standard, et
- des moyens de simulation de l'atténuation d'un câble de test.

Avantageusement les extrémités du câble sont équipées de deux contacts de type « quadrax » femelles. Les deux connecteurs sont des connecteurs de type RJ45.

Avantageusement le module de l'invention est réalisé dans un boîtier aplati directement sur un plan de masse avec un cuivre adhésif, avec une connexion tressée vissée sur ce plan de masse.

Avantageusement les moyens de simulation d'une atténuation comprennent au moins un isolateur connecté à un module de filtrage.

Dans un exemple de réalisation avantageux le module de l'invention comprend un câble avion apte à être relié à un équipement sous test, qui comprend une paire de fils pour émettre, et une paire de fils pour recevoir et, sur la voie transmission, un premier isolateur connecté à un premier module de filtrage et, sur la voie réception, un second isolateur relié à un second module de filtrage.

Avantageusement le module de test de l'invention est facile à installer, facile à utiliser, et permet des résultats reproductibles malgré les hautes fréquences mises en jeu.

### BRÈVE DESCRIPTION DES DESSINS

La figure 1 est une courbe en coordonnées logarithmiques représentant un signal transmis (en volts) en fonction de la fréquence (en MHz), illustrant le fonctionnement d'une méthode de test de l'art connu.
La figure 2 illustre le module de test de compatibilité électromagnétique de l'invention, dans une première configuration de test.
La figure 3 illustre un exemple de réalisation du module de test de l'invention.
La figure 4 est une courbe en coordonnées logarithmiques représentant un signal (en volts) en fonctions de la fréquence (en MHz) illustrant le fonctionnement du module de l'invention.
Les figures 5 et 6 illustrent deux configurations de test utilisant le module de l'invention.

### EXPOSÉ DÉTAILLÉ DE MODES DE RÉALISATION PARTICULIERS

Comme illustré sur la figure 2, le module de test de compatibilité électromagnétique d'une interface Ethernet haut débit embarqué sur avion de l'invention comprend :
- d'une part un câble 13, plus court que les câbles de test de l'art antérieur par exemple de moins de 1 mètre de long pour éviter toute atténuation, dont les extrémités sont équipés de deux contacts avion 14,
- d'autre part deux connecteurs standard compatibles d'un équipement de test standard 12, et
- des moyens de simulation de l'atténuation d'un câble de test.

Ce module réalise une interface entre le « monde avion » (à gauche sur la figure) et le « monde de test » (à droite sur la figure). Il permet une isolation entre ces deux mondes.

Ce module 10 est ainsi relié d'une part à un équipement sous test 11 qui est un calculateur avion que l'on cherche à tester, par exemple le calculateur de commandes de vol, et d'autre part à l'équipement de test 12, qui peut être, par exemple, celui décrit dans le document référencés [2] (équipements de test Ethernet) et [3] (service permettant de réaliser un test dénommé : « Bit error rate »).

Ainsi pour tester une interface AFDX, ce module comprend :
- d'un côté d'un câble 13, par exemple d'une longueur d'environ 50 cm, dont les extrémités sont équipées de deux contacts de type « quadrax » 14 (contacts avions) femelles, l'équipement (ou « End System ») AFDX à tester 11 étant équipé de contacts mâles,
- de l'autre côté de deux connecteurs de type RJ45 15 (interface de type PC ou « Personal Computer ») reliés aux émetteurs-récepteurs 16 de l'équipement de test 12, afin d'être compatible d'un équipement de test du commerce, et
- une carte électrique qui simule l'atténuation d'un câble de test.

Selon la méthode de test BCI, une injection de courant 17 est réalisée sur les deux voies du câble 13.

L'équipement de test 12 peut ainsi envoyer des messages (Trames) numérotés 1, 2.....n vers l'équipement sous test 11. L'équipement sous test 11 peut alors renvoyer ces messages. L'équipement de test 12 peut alors vérifier l'identité entre les messages envoyés et les messages reçus. S'il n'y a pas identité et qu'un message est corrompu, il y a un problème sur la ligne, et le test n'est pas acceptable.

L'équipement sous test 11 peut être muni d'une interface Ethernet haut débit. Mais le module de test de l'invention permet, également, de tester simultanément deux interfaces Ethernet haut débit grâce à ses deux voies.

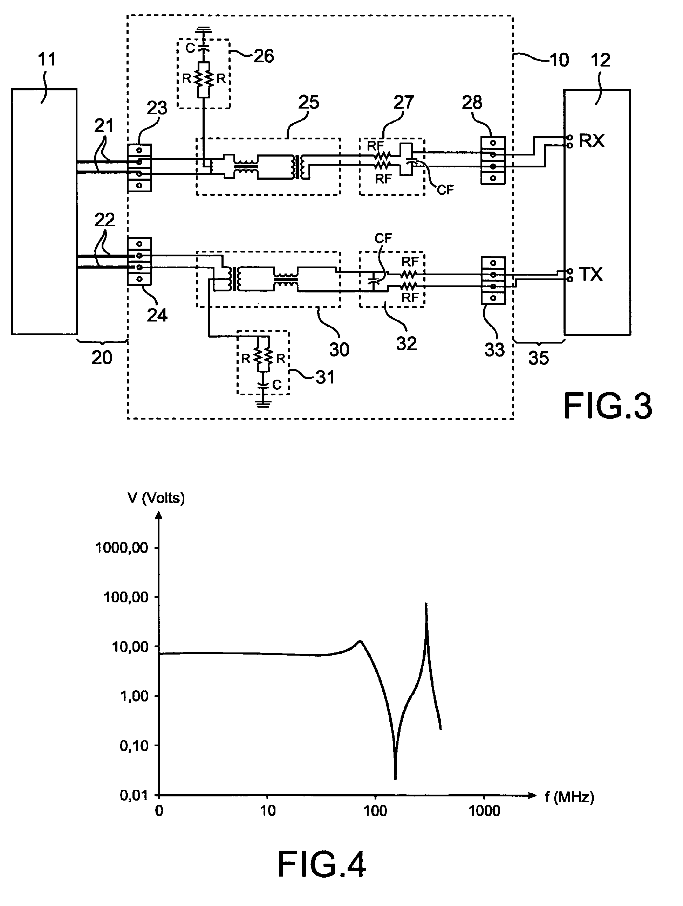

La figure 3 illustre un exemple de réalisation du module de test de l'invention 10 permettant ainsi de réaliser l'atténuation du signal et la protection électromagnétique des interfaces de l'équipement de test 12.

Cette figure illustre une seule voie de test,avec un câble avion 20 apte à être relié à l'équipement sous test 11, qui comprend une paire de fils 21 pour émettre (Tx), et une paire de fils 22 pour recevoir (Rx), connectés sur deux boîtiers 23 et 24.

Sur la voie transmission, un premier isolateur 25, associé à un ensemble 26 de deux résistances R (en parallèle pour pouvoir supporter un courant important) et d'une capacité C, est connecté à un premier module de filtrage 27 composé de deux résistances de filtrage RF et d'une capacité de filtrage CF, lui-même relié à un boîtier 28.

De même sur la voie réception un second isolateur 30, associé à un ensemble 31 de deux résistances R en parallèle et d'une capacité C, est relié à un second module de filtrage 32 connecté à un boîtier 33.

L'équipement de test 12 est relié aux boîtiers 28 et 33 par un câble Ethernet standard 35 le plus court possible.

Le réglage des composants RF et CF permet d'ajuster la valeur de l'atténuation désirée, en fonction de la longueur de l'avion.

Un tel module permet d'obtenir le signal illustré sur la figure 4, dans lequel les premières résonances (zones de sur test et de zones de sous test) sont repoussées au-delà de 80 MHz.

Le niveau de test passé sur des équipements avion est bien supérieur à 75 mA sur la bande 10 KHz-400 MHz comme défini au chapitre 20.4 du document référencé [1].

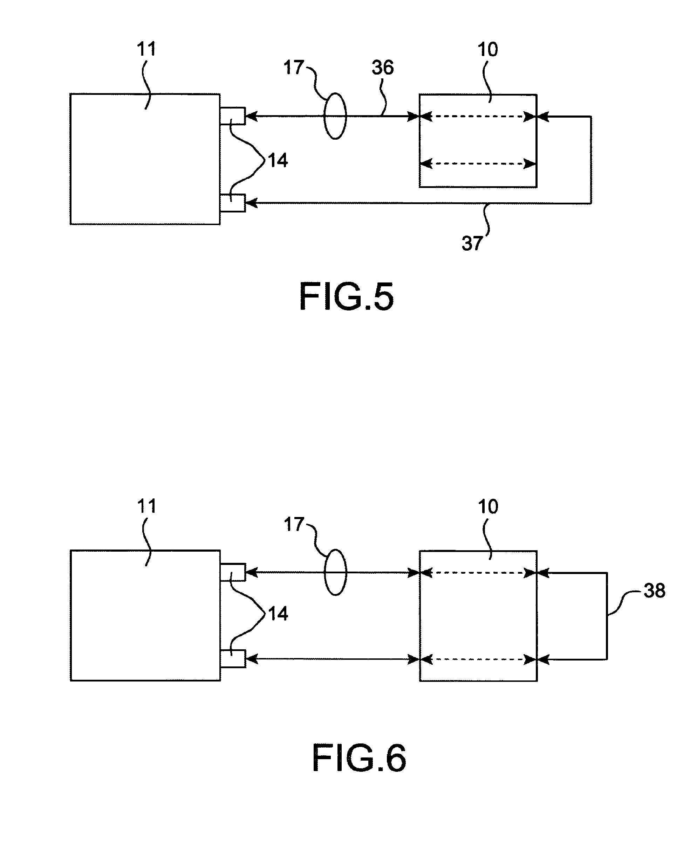

Le module de test de l'invention peut être utilisé dans trois configurations de test différentes.
- Dans une première configuration illustrée sur la figure 2, l'injection de courant est réalisé sur le câble 13.
- Dans une seconde configuration illustrée sur la figure 5, le module de test 10 de l'invention est rebouclé sur l'équipement sous test 11 au moyen d'un câble 37, qui relie une sortie de ce module à une entrée de l'équipement 11. L'injection de courant 17 a lieu sur le câble 36.
- Dans une troisième configuration illustrée sur la figure 6, le module de test de l'invention 10 a ses deux sorties reliées entre elles avec un câble de liaison 38 aussi court que possible reliant les deux contacts 15.

Dans un exemple de réalisation AFDX, le module de test de l'invention présente les caractéristiques suivantes :
- Il permet de tester deux équipements sous test 11 en même temps (4 ports AFDX) dans la première configuration de test.
- Le câble 13 utilisé du côté équipement sous test est un câble de 50 cm de long environ, dont les extrémités sont adaptées avec des contacts 14 de type « quadrax » femelle.
- La connexion du côté équipement de test est faite au travers de connecteurs 15 de type RJ45.
- Une encapsulation robuste et conductrice dans un boîtier permet une bonne liaison de ce module. Ce boîtier offre deux connexions au plan de masse classées par ordre de préférence pour garantir une connexion optimale :
   - un boîtier aplati directement sur le plan de masse avec un cuivre adhésif,
   - une connexion tressée pour être visée sur le plan de masse.

### REFERENCES

[1] Document de normalisation internationale RTCA / DO-160 (Chapitre 20, « Radiofrequency Susceptibility » pages 20-1 à 20-25, 29/7/1997)
[2] http://www.spirentcom.com/analysis/product_product. cfm?PL=33&PS=46&PR=378 (Spirent Communications, « Smartbits Metro Ethernet »)
[3] http://www.spirentcom.com/analysis/technology.cfm?w t=2&az-c=ss&SS=42 (Spirent Communication, BERT ou « Bit Error Rate Testing »)
[4] EP-A-513992 (Hewlett-Packard), 19.11.92
[5] JP-A-2003264469 (Hitachi), 19.9.03

## Revendications

1. Module de test de compatibilité électromagnétique d'au moins une interface Ethernet haut débit embarquée sur avion, **caractérisé en ce qu'**il comprend :
- un câble (13) de longueur inférieure à 1 mètre, dont les extrémités sont équipées de deux contacts avion (14) aptes à être reliés à un équipement sous test (11) comprenant une telle interface,
- deux connecteurs standard (15) compatibles d'un équipement de test standard (12), et
- des moyens de simulation de l'atténuation d'un câble de test.

2. Module selon la revendication 1, dans lequel le câble (13) a une longueur d'environ 50 cm.

3. Module selon la revendication 1, dans lequel les extrémités du câble (13) sont équipées de deux contacts de type « quadrax » femelles.

4. Module selon la revendication 1, dans lequel les deux connecteurs sont des connecteurs (15) de type RJ45.

5. Module selon la revendication 1, qui est réalisé dans un boîtier aplati directement sur un plan de masse avec un cuivre adhésif, avec une connexion tressée sur ce plan de masse.

6. Module selon la revendication 1, dans lequel les moyens de simulation d'une atténuation comprennent au moins un isolateur (25,30) connecté à un module de filtrage (27,32).

7. Module selon la revendication 6, qui comprend un câble avion (20) apte à être relié à un équipement sous test (11), qui comprend une paire de fils (21) pour émettre, et une paire de fils (22) pour recevoir et sur la voie transmission, un premier isolateur (25), connecté à un premier module de filtrage (27) et, sur la voie réception, un second isolateur (30), relié à un second module de filtrage (32).

## Claims

1. Module to test the electromagnetic compatibility of at least one high speed Ethernet interface onboard an aircraft, **characterised in that** it comprises:
- one cable (13) less than 1 meter long, the ends of which are fitted with two aircraft contacts (14) that can be connected to equipment under test (11) comprising such an interface,
- two standard connectors (15) compatible with standard test equipment (12), and
- means of simulating attenuation of a test cable.

2. Module according to claim 1, in which the cable (13) is about 50 cm long.

3. Module according to claim 1, in which the cable ends (13) are fitted with two female « quadrax » type contacts.

4. Module according to claim 1, in which two connectors are RJ45 type connectors (15).

5. Module according to claim 1, which is made in a flat box directly placed on a ground plane with adhesive copper, with a braided connection onto this ground plane.

6. Module according to claim 1, in which the means of simulating attenuation comprise at least one insulator (25,30) connected to a filter module (27,32).

7. Module according to claim 6, which comprises an aircraft cable (20) that can be connected to equipment under test (11), that includes one pair of wires (21) to transmit, and one pair of wires (22) to receive, and a first isolator (25) on the transmission channel connected to a first filter module (27), and a second isolator (30) on the reception channel connected to a second filter module (32).

## Patentansprüche

1. Testmodul der elektromagnetischen Kompatibilität mit mindestens einer Hochgeschwindigkeits-Ethernet-Schnittstelle, die in einem Flugzeug mitgeführt wird, **dadurch gekennzeichnet, dass** es umfasst:
- ein Kabel (13) mit einer Länge unter 1 Meter, dessen Enden mit zwei Flugzeugkontakten (14) ausgestattet sind, welche mit einer eine solche Schnittstelle aufweisenden, im Test befindlichen Einrichtung (11) verbunden werden können,
- zwei Standard-Verbinder (15), die mit einer Standard-Testeinrichtung (12) kompatibel sind, und
- Mittel zur Simulation der Dämpfung eines Testkabels.

2. Modul nach Anspruch 1, wobei das Kabel (13) eine Länge von etwa 50 cm hat.

3. Modul nach Anspruch 1, wobei die Enden des Kabels (13) mit zwei weiblichen Kontakten vom "Quadrax"-Typ ausgestattet sind.

4. Modul nach Anspruch 1, wobei die beiden Verbinder Verbinder (15) vom RJ45-Typ sind.

5. Modul nach Anspruch 1, das in einem direkt auf einer Masseebene mit klebfähigem Kupfer flach aufgebrachten Gehäuse mit einer auf dieser Masseebene verdrillten Verbindung hergestellt ist.

6. Modul nach Anspruch 1, wobei die Mittel zur Simulation einer Dämpfung mindestens einen mit einem Filtermodul (27,32) verbundenen Isolator (25,30) umfassen.

7. Modul nach Anspruch 6, das ein Flugzeugkabel (20) aufweist, welches mit einer im Test befindlichen Einrichtung (11) verbunden werden kann, welche ein Drahtpaar (21) zum Senden und ein Drahtpaar (22) zum Empfangen, sowie auf dem Übertragungsweg einen ersten Isolator (25), der mit einem ersten Filtermodul (27) verbunden ist, und auf dem Empfangsweg einen zweiten Isolator (30), der mit einem zweiten Filtermodul (32) verbunden ist, umfasst.
